Europäisches Patentamt

European Patent Office

Office européen des brevets

(19)

(11)  **EP 1 717 285 A1**

## (12)  EUROPEAN PATENT APPLICATION

(43) Date of publication:
**02.11.2006 Bulletin 2006/44**

(51) Int Cl.:
*C09G 1/02* (2006.01)    *H01L 21/304* (2006.01)

(21) Application number: **05009069.5**

(22) Date of filing: **26.04.2005**

(84) Designated Contracting States:
**AT BE BG CH CY CZ DE DK EE ES FI FR GB GR HU IE IS IT LI LT LU MC NL PL PT RO SE SI SK TR**
Designated Extension States:
**AL BA HR LV MK YU**

(71) Applicant: **BASF Aktiengesellschaft**
**67056 Ludwigshafen (DE)**

(72) Inventors:
• **Hensen, Karl, Dr.**
  **Peitou District, Tapei Country 112, (TW)**
• **Shen, Kwo-Hung**
  **Junghe City, Taipei Country 235, Taiwan (TW)**
• **Chen, Ruey-Fang**
  **Longjing Township, Taichung Contry 434 (TW)**

## (54)  Self stabilizing CMP composition for metal layers

(57)    The present invention concerns to a new slurry composition comprising Fe-containing $SiO_2$ particles uniformly dispersed in a stable aqueous medium, which is useful in chemical mechanical polishing of metal layers. The Fe-containing $SiO_2$ particles provide an improved result during chemical mechanical polishing. Additionally, Fe-containing $SiO_2$ particles provide a self-stabilizing effect to the $SiO_2$-based abrasives in the aqueous dispersion, and also act as catalyst during the chemical mechanical polishing operation. Particularly the new chemical mechanical polishing slurry composition is suitable for use in global planarization of tungsten films on wafer surfaces.

EP 1 717 285 A1

**Description**

**BACKGROUND OF THE INVENTION**

**Technical Field of the Invention**

The present invention concerns to a chemical mechanical polishing (CMP) slurry composition for semiconductor device planarization. More particularly, the present invention relates to a self-stabilizing CMP slurry composition composed for planarizing tungsten layers on wafer surfaces with improved polishing stability.

**Background of the Invention**

An integrated circuit (IC) chip consists of an array of devices whose contacts are interconnected by patterns of metal wirings. In VLSI chips, these metal patterns are multi-layered and separated by layers of insulating material. Interconnections between different levels of metal wiring patterns are made by vias, which are etched through said layers of insulating material. As the level of integration continues to increase, an integrated circuit having multiple layers of conductive metal is not unusual. A multi-layered interconnect IC architect normally has a first layer of metallization, an interconnection layer, a second level of metallization, a second interconnection layer, and a third and subsequent levels of metallization and interconnection layer. Interlevel dielectrics (ILD) such as doped/undoped $SiO_2$, aerogel $SiO_2$ and low-$\kappa$ polymer can be used to isolate electrically the different levels of metallization. The electrical connections between different interconnection levels are made through the use of metal vias, and in particular tungsten vias. In patents US 4,789,648, US 4,702,792 and US 4,956,313, which are incorporated herein by reference, methods for preparing multiple metal layers and metal vias in insulator films are disclosed. In a similar manner, metal contacts are used to form electrical connections between interconnection levels and devices formed in a well. The metal vias and contacts are generally filled with tungsten and generally employ an adhesion layer such as titanium and/or titanium nitride (TiN) to adhere a metal layer such as a tungsten metal layer to $SiO_2$, and also serve as a barrier layer preventing tungsten from chemically reacting with $SiO_2$ through direct contact.

In a semiconductor manufacturing process, conductive contacts are formed by a blanket tungsten deposition followed by a chemical mechanical polish (CMP) step. In a typical process, via holes are etched through an interlevel dielectric layer to interconnection lines or to a semiconductor substrate. Subsequently, a thin adhesion layer such as Ti/TiN is generally formed over the ILD and is directed into the etched hole, followed by depositing a tungsten film blanket over the adhesion layer and filling into the via. Finally, the excess tungsten is removed by a chemical mechanical polishing (CMP) process to form metal vias. Processes of CMP for ILD or tungsten are disclosed in US 4,910,155, US 4,956,313, and US 4,944,836.

A requirement for a planarization process is to remove undesired material from the ILD surface to ensure an adequate depth-of-focus for subsequent photolithography. The chemical mechanical polishing technique offers a global planarization method for wafer surfaces (millimeters in area instead of the usual nm dimensions).
In a typical chemical mechanical polishing process, the surface to be polished is placed in direct contact with a rotating polishing pad. A robotic carrier applies pressure against the backside of the wafer. During the polishing process, the pad and table are rotated while a downward force is maintained against the substrate back. An abrasive solution, commonly referred to as a "slurry" is dispensed onto the pad surface during polishing. The slurry initiates the polishing process by chemically reacting with the film being polished. The polishing process is facilitated by the rotational movement of the pad relative to the substrate as slurry is delivered to the wafer/pad interface. Polishing of metal film is finished until the metal film on the insulator is completely removed.

The challenge of the process is to control chemical reaction, mechanical polishing and maintain a high selectivity (polishing preference) without damaging the desired features. The composition of polishing slurries is thus one of the most critical factors affecting the performance of CMP operation. Typically CMP slurries contain abrasive materials suspended in de-ionized water together with various additives to enhance the polishing performance. For example, in US 5,209,816, (Yu et al) a slurry mixture containing perchloric acid, hydrogen peroxide and water-based solid abrasive is disclosed. Another comparable slurry composition containing aluminum oxide, hydrogen peroxide and potassium hydroxide or ammonium hydroxide is disclosed in US 5,244,534 (Yu et al). This type of slurries is suitable for removing tungsten layers at a predefined speed accompanied by the removal of small portions of the underlying insulation layers. Cadien and Feller (US 5,340,370) describe slurry mixtures for polishing tungsten. The disclosed slurry contains 0.1 M potassium ferricyanide, 5 % by weight of $SiO_2$ in potassium acetate and some acetic acid. The pH value of this slurry composition is in the range of 2 to~ 4.

CMP slurries contain nanoparticles of metal oxides, which are dispersed in aqueous solution. In the slurry, a special "force" is active, that is defined as either the surface potential or the hydration force of the metal oxide particles. This force must be sufficient to repel and overcome the van der Waals forces to avoid the formation of agglomerates of large size.

Large particles would scratch the polished surface. In order to keep the particles from forming large agglomerates and to avoid sedimentation of abrasive particles, additives such as acids, alkalis, metal salts and polymer surfactants are used to improve the suspension capability. It is known, that Fe ions are very effective to keep colloidal $SiO_2$ from sedimentation. Addition of Fe ions to $SiO_2$ slurries is beneficial for stabilizing $SiO_2$ suspensions and thus is reducing surface defects, especially scratches. A better stability of colloidal suspension further indicates a longer shelf life of the CMP slurry products.

In order to increase the polishing rate of tungsten as well as to improve the degree of planarization, oxidizing agents, like hydrogen peroxide or other peroxide materials, are added into the polishing slurry shortly before it will be delivered to the CMP platen. However, the oxidizing agent dissociates at a relatively high rate after being added into known slurry compositions. This results in a continuous reduction of the polishing rate as well as in a decreased polishing steadiness. Therefore, it is a crucial point to keep under control the dissociation of the oxidizing agent in order to preserve a stable activity of the applied polishing composition, so that the CMP process can be kept steady and stable throughout the whole operation.

This means, that there is a strong need for a new CMP composition with prolonged shelf life and improved polishing stability and which is tailored for polishing a tungsten layer. There is also a need for such compositions showing improved CMP yields and leading to a reduction of surface defects.

## SUMMARY OF THE INVENTION

In view of the foregoing, this invention provides a CMP slurry composition having long-term stability and activity and capable of increasing the polishing rate of metal, especially of tungsten, so that patterns can be formed with high reliability to improve the yield and the throughput of the product.

It is also an object of this invention to provide an improved - chemical mechanical polishing (CMP) slurry composition for polishing tungsten having an excellent polishing stability throughout the polishing operation.

Especially, it is an object of this invention to provide a CMP slurry composition for tungsten having good chemical long-term stability for extended shelf life, which enables to use the slurry composition in CMP processing for IC interconnect applications.

To achieve these and other advantages and in accordance with the purpose of this invention, as embodied and broadly described herein, this invention provides a CMP slurry composition comprising an Fe-containing $SiO_2$ metal oxide abrasive as an essential component. The Fe-containing $SiO_2$ metal oxide abrasive is used to provide a steady mechanical polishing action during polishing. Besides, it provides self stabilizing effects to the $SiO_2$ abrasive particles in the aqueous dispersion and acts as catalyst during the chemical mechanical polishing operation. Furthermore, the additive enhances the polishing selectivity and stability of the chemical mechanical polishing composition.

Another object of the present invention is the use of the new slurry composition in a method for polishing wafers comprising at least one tungsten layer. In order to carry out this method CMP slurry compositions, comprising a Fe-containing $SiO_2$ metal oxide abrasive, de-ionized water and at least an additive, are applied to polish the wafers, and a pad is brought into contact with the wafers for a length of time sufficient to remove at least a portion of the upper tungsten layer from the wafer surface.

## Brief Description of The Drawings

FIG. 1 is a transmission electron micrograph (TEM) showing metal oxide particles of Fe-containing $SiO_2$ of the present invention at 100000X magnification. (Use VP 3599 - 200)

FIG. 2 is an aggregate size distribution for metal oxide particles of Fe-containing $SiO_2$ (lower Fe content, Use VP 3599 - 200) for use in the polishing slurry of the present invention, dispersed by high-speed high-shear mixing. Show Horiba result!

FIG. 3 is an aggregate size distribution for metal oxide particles of Fe-containing $SiO_2$ (higher Fe content, $SiO_2$ coated Fe Oxide) for use in the polishing slurry of the present invention, dispersed by jet milling for XX rounds or for XX minutes.

FIG. 4 illustrates a theoretical plot of pH on the x-axis versus zeta potential in millivolts on the y-axis. The samples are Fe-containing $SiO_2$-based slurries of the present invention. (for comparison, use VP 3599 - 200, SiO2 coated Fe Oxide and monolithic fumed $SiO_2$)

**FIG. 5** illustrates the self-stabilizing effect of the slurries; one comprising Fe-containing $SiO_2$ (Use VP 3599 - 200), and the other monolithic fumed $SiO_2$ with Fe salt addition. An accelerated shelf life test is conducted to compare the difference between the two slurries. The x-axis indicates the time period and the y-axis indicates the large particle counts.

**FIG. 6** illustrates the $H_2O_2$ disassociation rates of two slurries after $H_2O_2$ is added to mix with slurries, one is Fe-containing $SiO_2$ based slurry, and the other monolithic fumed $SiO_2$ with Fe salt addition.

**FIG. 7** illustrates the polishing rate of tungsten and selectivity to thermal oxide for a series of wafers utilizing the polishing slurry of the present invention. The x-axis indicates the wafer number and the y-axis indicates the polishing rate of tungsten in A/minute. (Use VP 3599 - 200 and monolithic fumed $SiO_2$ with Fe salt addition, selectivity comparison)

**FIG. 8** illustrates the polishing rate decay of tungsten with time, due to $H_2O_2$ decomposition with time after $H_2O_2$ is added to mix with slurries, i.e., one is Fe-containing $SiO_2$ particle based slurry, and the other is monolithic fumed $SiO_2$ with Fe salt addition. The x-axis indicates the time period and the y axis indicates the polishing rate per minutes. (Use VP 3599 - 200).

**Detailed Description of the Invention**

The present invention concerns to the use of an Fe-containing $SiO_2$ abrasive as an essential metal oxide ingredient of a CMP slurry 25 suitable for use in fabricating semiconductor devices. The Fe-containing $SiO_2$ abrasive, a feature of the present invention, can be prepared from high purity $SiCl_4$ and $FeCl_3$ materials by pyrogenic flame method, where doping or co-fuming process can be selected to produce different metal oxides, e.g., doped fumed $SiO_2$ or composited $SiO_2$ with (an)other metal oxide(s). As described in US 6,406, 532 high purity $SiCl_4$ and $FeCl_3$ materials are firstly volatilized in two separate evaporators at different evaporating temperatures. The chloride vapors are introduced into the mixing chamber of a burner by means of nitrogen. They are mixed with hydrogen and dry air and/or oxygen and burned in a reaction chamber. The reaction products are cooled to about 100°C in the coagulation section. Then the mixed oxides obtained are separated using a filter. Adhering chloride is removed by treatment with moist air at a temperature in the range of 500 and 700°C. The metal oxide particles thus obtained are not simply mechanically mixed oxides of Si and Fe or particles wherin $SiO_2$ and $Fe_2O_3$ are simply mixed. The particles consist of doped oxides, showing characteristic physical and chemical properties, which are quite different from a simple mixture of the two components. For example, physical properties of Fe-doped $SiO_2$, based on "VP 3599", a product code of Degussa, are summarized in Table 1. In FIG. 1, a TEM (transmission electron micrograph) photo shows the morphology of the metal oxide particles of Fe-doped $SiO_2$ in the slurry of the present invention. The Fe-doped $SiO_2$ has a lower Fe content. Another fumed product also provided by Degussa, and consists of $SiO_2$-coated $Fe_2O_3$, in which $SiO_2$ coats crystalline $Fe_2O_3$. The physical properties are shown in Table 2.

According to the present invention the content of iron oxide further can be adjusted in the composition by the addition of monolithic fumed $SiO_2$ as well as of Fe-doped $SiO_2$, and $SiO_2$-coated $Fe_2O_3$ in different amounts.

TABLE 1

Physical Properties of Fe-doped $SiO_2$ 200 (based on VP 3599) Specific Surface Area (BET) $200 \pm 20$ m$^2$/g

| | |
|---|---|
| pH | 4-6 |
| Isoelectric Point | 6-7 |
| $Fe_2O_3$ Content | 0.6 wt % (<2.0 wt % adjustable) |
| $SiO_2$ Content | 99.4 wt% |
| Bulk density | 60-100 g/l |
| Cl Content | <0.5 wt % |

TABLE 2

Physical Properties of $SiO_2$ coated Iron Oxide:

| | |
|---|---|
| Matrix : | Silica/Iron Oxide |
| $Fe_2O_3$ Content | 20-80 wt % |
| Surface area | 60-200 m$^2$/g |
| Domain size: | 5-25 nm |

Suitable Fe-containing $SiO_2$ particles for use in polishing slurries show primary particle sizes in the range of between 10 and 100 nm and preferably in the range of between 10 and 40 nm as measured in BET. A sharp decrease of removal rate can be observed, if the primary particle size is smaller than 10 nm. Another undesired effect resulting from the use of small particle sizes is an increase of dispersion difficulties, and subsequently a rise in dispersion viscosity. On the other hand, when the primary particle size is larger than 100 nm, an increased removal rate is obtained, but also the probability of severe scratching is increased.

For CMP slurries of the present invention it is important that the aggregates of the metal oxide particles are uniformly dispersed in a stable aqueous medium. This means that the aggregates have to stay isolated and well distributed throughout the medium and the aggregates shall not re-agglomerate and settle to form a dense, hard sediment. Only if this is achieved, the slurries can be an improved alternative to conventional slurries. According to the present invention, the added metal oxides form particle aggregates in an aqueous dispersion. The particle size of the aggregate is named a secondary particle size or, more precisely an aggregate size. The aggregate size of the particles refers to the measurement of the branched, three dimensional chains of fused primary particles (individual molten spheres). The mean aggregate size of this invention preferably has a maximum aggregate size smaller than 1.0 $\mu$m and a mean aggregate size smaller than 0.4$\mu$m. This type of abrasive is ideal for reducing or preventing the formation of scratch marks, trench holes or other defects on the wafer surface. The size distribution of the abrasive material can be determined by a particle size analyzing device such as Horbia 920. FIGS. 2 and 3 illustrate aggregate size distributions for metal oxide particles of the present invention for two different types of Fe-containing $SiO_2$ disperse by two different approaches.

In a preferred embodiment the metal oxide particles must have a maximum zeta potential greater than XXX millivolts in order to keep the slurry in a well-suspended state. Zeta potential is the potential difference, measured in a liquid, between the shear plane and the bulk of the liquid beyond the limits of the electrical double layer. The size of the double layer will depend firstly on the amount of charge on the particle surface. A large charge, whether positive or negative, will result in a large double layer that stops particles getting close to each other because of their electrostatic repulsion which is induced between particles carrying the same electrical charge. This is a typical situation for stable (deflocculated) suspensions having low viscosities. In the present invention, the viscosity values of the slurry compositions provide a very good and quick indication to judge promptly the quality of dispersion operation. Conversely, a low surface charge requires only few counter ions and result in thinner double layers, thus resulting in particle flocculation and high suspension viscosity.

All metal oxide particles result in a charge when dispersed in water. In case of $SiO_2$, this is due to surface silanol (Si-OH) groups losing a proton. The aqueous phase becomes slightly acidic (since it receives protons) while the $SiO_2$ particle surface becomes negative (due to the formation of Si-O⁻). The charged particle surface then attracts a layer of counter ions from the aqueous phase. In case of $SiO_2$ positive ions will crowd the surface. Due to ionic radii considerations, the strongly adsorbed counter ions will not fully offset the surface charge. Then a second layer of more loosely held counter ions is formed. At a certain distance from the particle surface, the surface charge will be fully balanced by counter ions. Beyond this point, a balance of negative and positive electrolyte is present in the bulk suspensions.

The zeta potential of a metal oxide suspension is dependent on the pH of the aqueous medium. For a given metal oxide particle composition, the isoelectric point (IEP) is defined as the pH at which zeta potential is zero. Usually good dispersion results can be achieved by conducting the dispersion at the pH of the isoelectric point. After dispersion, the pH of the dispersion is increased or decreased off from the isoelectric point; the surface charge is then increased negatively or positively, respectively. As the pH continues to increase or to decrease, the surface charge will reach a maximum zeta potential. For the Fe-containing $SiO_2$ of the present invention, the zeta potential is dependent on the pH of the aqueous medium, as shown in FIG. 4. In general, the isoelectric point can be well defined. It should be noted that the maximum zeta potential and isoelectric point are functions of the metal oxide composition and that the maximum zeta potential can be affected by the addition of salts to the aqueous medium.

The particle charge influences the double layer size as well as the zeta potential. If the zeta potential of a component is unsatisfactory, there are different possibilities to alter the situation. Firstly, surfactants can be added to the suspension. These compounds are adsorbed onto the particle surface to alter the surface charge; i.e., steric (these surfactants keep particles apart by virtue of the space occupied by the organic surfactant molecules when attached to the particle), electrostatic (particle surface charge is altered purely by virtue of the charge present on the adsorbed surfactant molecule), and electrosteric (a mixture of what is mentioned above). Secondly, soluble ions can be added to manipulate the zeta potential by changing the concentration and valence of soluble ions in the suspension. For example, a $Na^+$ or $K^+$ ion in $SiO_2$ dispersion can be replaced by a single $Ca^{2+}$ ion for a more compressed double layer and increased flocculation.

In the present invention, instead of adding surfactants or soluble ions (from metal salts) to stabilize the $SiO_2$ dispersion, Fe-containing $SiO_2$ particles are used to provide a self-stabilizing effect. The zeta potential of this invention is determined by measurement of the electrokinetic sonic amplitude using the Matec MBS-8000 instrument (?). The pH of the Fe-containing $SiO_2$ dispersion is lowered to the range of 2 to 4 to meet the requirement for metal CMP application.

As for the solid content of the Fe-containing $SiO_2$ powder, it is in the range of from 1 to 50 % by weight based on the total weight of the polishing composition and preferably in the range of from 1 % to 12% by weight. If the solid content is too low, desired polishing effects cannot be obtained. The solid content of Fe-containing $SiO_2$ must be further confined to a very narrow range as to obtain a very precise polishing process control. For example, if applied to a metal CMP process for semiconductor device fabrication, the polishing composition comprising Fe-containing $SiO_2$ as main abrasive most preferably the solid content should be in the range of from 2 % to 8 % by weight.

The metal oxide is slowly added to deionized water to form a colloidal dispersion. The deionized water may be pH adjusted in advance for a better dispersion result. The slurry also may comprise a high weight percentage of solid during dispersion process. The dispersion process is completed by employing high-speed high-shear mixing using conventional dispersion methods. A more efficient way is the method using a jet milling process to break down the three-dimensional chain structure of fused fumed particles. After dispersion, the pH value of slurry is adjusted according to the predetermined value, and the slurry is thus stabilized in a colloidal state. For the best performance, various additives capable of providing specified functions may be added to the abrasive solution further. In addition, the aforementioned abrasive may also include a colloidal abrasive or a fumed abrasive such as colloidal $SiO_2$, fumed $SiO_2$, fumed $FeO_3$ or other co-fumed metal oxides, for example.

The CMP slurry of the present invention comprises at least one stabilizer. The abrasive stabilizer can be added to stabilize the surface charge of the abrasive particles, prevent the growth of abrasive particles inside the slurry, and thus preserve the long-term stability of the slurry under the acidic environment. In the CMP slurry of the present invention, the abrasive stabilizer used is Fe ions, and the Fe content can be adjusted via varying the dosage of Fe on the particle surface during the pyrogenic flame process or the content of different Fe-containing $SiO_2$ during dispersion process. According to the present invention, the content of Fe ions is in the range of about 0.001 % to 2.0 % by weight. Preferably, the content of Fe ions is in the range of about 0.005 % to 0.5 % by weight, and most preferably the content of Fe ions is in the range of about 0.01 % to 0.05 % by weight.

The CMP slurry of the present invention comprises at least an acid as an additive for adjusting the pH value of the CMP slurry. A suitable acid can be selected from the group of organic acids or that of inorganic acids or of their mixtures. Suitable acids for the above-mentioned use may be chosen especially from the group hydrochloric acid, nitric acid, formic acid, acetic acid. Also other acids may meet the requirements of the present invention and may be added and which are not named here. The acids may be added to the CMP slurry in an amount of about 0.1 % to 15% by weight. Preferably, the pH of the CMP slurry is adjusted to a value of 2 to 4.

The CMP slurry of the present invention is suitable for polishing metal layers, preferably a tungsten layers. However, its use is not limited to the polishing of any specific semiconductor films or integrated circuit films. The CMP slurry of this invention can be applied to polish other films, surfaces and wafers, too.

As such the CMP slurry is a chemical agent for assisting a chemical mechanical polishing operation. The CMP slurry can be used as the only media in a chemical mechanical polishing operation or together with one or more further CMP slurry or slurries. The CMP slurry composition of the present invention may also be used together with an oxidizing agent. An oxidizing component is used to oxidize a metal layer to its corresponding oxide, such as metal tungsten into tungsten oxide, metal aluminum into aluminum oxide and metal copper into copper oxide. In experiments according to the present invention, the tungsten layers are polished mechanically to remove the tungsten oxide formed on the surface oxidized by an oxidizing agent. It has been found, that a wide range of oxidizing agents may be used; preferred components include oxidizing metal salts, oxidizing metal complexes, nitrates, peroxides, persulfates, perchlorates, EDTA, citrates, potassium ferricyanide, Fe salts, aluminum salts, sodium salts, potassium salts, phosphonium salts, ammonium salts or ozone water used alone or in combination with at least two of the compounds, for example.

The CMP slurry composition of the present invention may comprise a selectivity enhancer, e.g., tetramethyl ammonium hydroxide, to enhance the polishing selectivity between dielectric layer and metal layer. Further the composition may comprise an oxidant stabilizer, e.g., maleic acid, to stabilize for the oxidizing agent such as $H_2O_2$.

Furthermore, the CMP slurry composition of the present invention may comprise further additives such as surfactants, hydroxides or dispersing agents.

The CMP slurry composition of the present invention is suitable to suppress the polishing rate of dielectric material while increasing the polishing rate of metal layer. Hence, comprising an appropriate amount of selectivity enhancer the CMP slurry is particularly suitable to increase the chemical mechanical polishing rate of tungsten.

CMP slurries of the present invention remain in a stable state for a long time. Therefore, improved polishing uniformity and production yields are attained using the CMP slurry of this invention even after long-term storage.

Fe-containing particles of slurries according to the present invention release Fe-ions at a steady rate to support a stable chemical reaction between slurry and tungsten layer. During polishing particle crushing and collision induce the release of Fe ions, and therefore the degree of Fe ion release can be closely related to the mechanical parameter of polishing, e.g., down load force and table speed.

It will be apparent to those skilled in the art that various modifications and variations can be made to the structure of the present invention without departing from the scope or spirit of the invention. In view of the foregoing, it is self-explaining that the present invention covers modifications and variations of this invention provided they fall within the scope of the following claims and their equivalents.

**Examples**

Example 1

Two polishing slurries were prepared.
The first slurry contains 3 % by weight of $SiO_2$ containing Fe, additives (without Fe salt) and deionized water as remainder. The second slurry consists of 3 percent by weight of fumed silica, additives (also including ferric nitrate) and the remainder deionized water. An accelerated shelf life test was conducted by circulating slurry at a predetermined high flow rate to create severe shearing. In the test, 40 kg of slurry are used per test. A particle counter is used to count the number of large particles every 1 hour for 48 hours. Fig. 5 illustrates the improved stability of the slurry of the present invention by use of Fe containing $SiO_2$.

Example 2

Two polishing slurries are prepared. The first slurry consists of 3 % by weight of Fe containing $SiO_2$, additives (without Fe salt) and the remainder deionized water. The second slurry consists of 3 % by weight of fumed silica, additives (also including ferric nitrate) and the remainder deionized water. 3 % by weight (of slurry) $H_2O_2$ is added to be mixed together with the slurry composition. For a period of 48 hours the content of $H_2O_2$ is checked every hour. Fig. 6 illustrates the $H_2O_2$ stability of the slurry of the present invention by use of Fe containing $SiO_2$.

Example 3

Two polishing slurries are prepared. The first slurry consists of 3 % by weight Fe containing $SiO_2$, additives (without Fe salt) and the remainder deionized water. The second slurry consists of 3 weight percent fumed silica, additives (also including ferric nitrate) and the remainder deionized water. 3 % by weight (of slurry) $H_2O_2$ is added to be mixed together with the slurry composition. The slurries of the present invention are used to polish silicon dioxide and tungsten layers on a wafer using a Westech-372 CMP polisher with parameters listed as follows;

Download pressure = 4 psi;

Back pressure = 2 psi;

Platen speed = 60 rpm;

Carrier speed = 57 rpm;

Flow rate of slurry = 140 ml/minute; and Polishing time = 60 seconds.

The thickness of the thin film is measured using a Nanoscope (from Nanometrics Nanospec) before and after polishing. The polishing rate is thus determined, as illustrated in FIG. 7.
As described hereinbefore, the polishing composition of the present invention is superior in shelf life and polishing stability for use in the global planarization of a tungsten layer on the device wafer surfaces.

**Claims**

1.   Slurry composition with increased stability for use in chemical mechanical polishing during semiconductor production comprising self-stabilizing Fe-containing $SiO_2$ particles uniformly dispersed in an aqueous dispersion.

2. Slurry composition according to claim 1 comprising Fe-containing $SiO_2$ particles uniformly dispersed in an aqueous dispersion and acting as a catalyst during the chemical mechanical polishing operation.

3. Slurry composition according to claims 1 or 2, comprising Fe-containing $SiO_2$ particles in an amount in the range of from 2 to 8 % by weight based on the total weight of slurry composition.

4. Slurry composition according to claims 1 to 3, comprising Fe-containing $SiO_2$ prepared by a pyrogenic flame method.

5. Slurry composition according to claims 1 to 3, comprising $SiO_2$-coated $Fe_2O_3$ particles in which $SiO_2$ coats crystalline $Fe_2O_3$.

6. Slurry composition according to claims 1 to 3, comprising Fe-containing $SiO_2$ particles prepared by a pyrogenic flame method and/or $SiO_2$-coated $Fe_2O_3$ particles, in which $SiO_2$ coats crystalline $Fe_2O_3$, and/or $SiO_2$ particles as abrasives.

7. Slurry composition according to one or more of the claims 1 to 6, wherein said Fe-containing $SiO_2$ particles and/or $SiO_2$-coated $Fe_2O_3$ particles contain sufficient Fe ions to provide a self-stabilizing effect to $SiO_2$ particles in CMP slurry an extended shelf life.

8. Slurry composition according to one or more of the claims 1 to 6, wherein the content of Fe ions within the abrasive is in the range of from 0.001 % to 2.0 % by weight based on the total weight of slurry composition.

9. Slurry composition according to one or more of the claims 1 to 6, wherein the content of Fe ions within the abrasive is in the range of from 0.01 % to 0.5 % by weight based on the total weight of slurry composition.

10. Slurry composition according to one or more of the claims 1 to 9, wherein said Fe-containing $SiO_2$ particles have a surface area in the range of about 10 to 300 $m^2/g$, preferably in the range of about 50 to 200 $m^2/g$.

11. Slurry composition ccording to one or more of the claims 1 to 9, wherein said Fe-containing $SiO_2$ particles have a primary particle size in the range of about 10 to 40 nm, and a mean aggregate size of not larger than 0.4 $\mu$m and a maximum aggregate size no larger than 1.0 $\mu$m in the aqueous dispersion.

12. Slurry composition according to one or more of the claims 1 to 11, comprising high-purity deionized water, organic acid, inorganic acid, alkyl ammonium derivative and mixtures thereof.

13. Use of a slurry composition according to one or more of the claims 1 - 12 for polishing semiconductor devices comprising thin films made of a material selected from the group Si, $SiO_2$, Ti, TiN, and W.

**European Patent Office**

**EUROPEAN SEARCH REPORT**

Application Number

EP 05 00 9069

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 6 464 740 B1 (TOWERY DANIEL I ET AL) 15 October 2002 (2002-10-15) * column 10, line 22 * * column 10, lines 44-54 * * column 11, line 62 - column 12, line 4 * * column 14, lines 46-54; claims 1-3,22-25 * | 1-7,13 | C09G1/02 H01L21/304 |
| A | | 4 | |
| X | US 2003/005647 A1 (TOWERY DANIEL ET AL) 9 January 2003 (2003-01-09) * paragraphs [0060] - [0071] * * paragraph [0082]; claims 1-6 * | 1-3,5-13 | |
| A | | 4 | |
| A | US 6 517 628 B1 (PFAFF GERHARD ET AL) 11 February 2003 (2003-02-11) * the whole document * | 1-13 | |
| D,A | US 6 406 532 B1 (HARTMANN WERNER ET AL) 18 June 2002 (2002-06-18) * the whole document * | 1-13 | TECHNICAL FIELDS SEARCHED (Int.Cl.7) C09G H01L C23F C09K |

The present search report has been drawn up for all claims

| Place of search | Date of completion of the search | Examiner |
|---|---|---|
| Munich | 13 October 2005 | olde Scheper, B |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 05 00 9069

This annex lists the patent family members relating to the patent documents cited in the above-mentioned European search report.
The members are as contained in the European Patent Office EDP file on
The European Patent Office is in no way liable for these particulars which are merely given for the purpose of information.

13-10-2005

| Patent document cited in search report | | Publication date | Patent family member(s) | | Publication date |
|---|---|---|---|---|---|
| US 6464740 | B1 | 15-10-2002 | JP | 2000080352 A | 21-03-2000 |
| US 2003005647 | A1 | 09-01-2003 | NONE | | |
| US 6517628 | B1 | 11-02-2003 | AT | 301170 T | 15-08-2005 |
| | | | CN | 1273258 A | 15-11-2000 |
| | | | DE | 19917388 A1 | 19-10-2000 |
| | | | EP | 1045014 A2 | 18-10-2000 |
| | | | JP | 2000345096 A | 12-12-2000 |
| US 6406532 | B1 | 18-06-2002 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4789648 A
- US 4702792 A
- US 4956313 A
- US 4910155 A
- US 4944836 A

- US 5209816 A, Yu
- US 5244534 A, Yu
- US 5340370 A, Cadien and Feller
- US 6406532 A